# FASCICULE DE BREVET EUROPEEN

(11) **EP 1 194 951 B1**
(45) Date de publication et mention de la délivrance du brevet: **09.09.2009**
(21) Numéro de dépôt: 00949578.9
(22) Date de dépôt: 29.06.2000
(51) Int. Cl.: H01L 21/20, H01L 21/762

(54) **PROCEDE DE REALISATION D'UN FILM MINCE UTILISANT UNE MISE SOUS PRESSION**
HERSTELLUNG EINES DÜNNEN FILMS UNTER ANWENDUNG VON DRUCK
METHOD FOR MAKING A THIN FILM USING PRESSURISATION

(30) Priorité: 30.06.1999 FR 9908379
(43) Date de publication de la demande: 10.04.2002
(73) Titulaire: COMMISSARIAT A L'ENERGIE ATOMIQUE, 75015 Paris (FR)
(72) Inventeur: ASPAR, Bernard, F-38140 Rives (FR); BRUEL, Michel, F-38113 Veurey (FR); MORICEAU, Hubert, F-38120 Saint Egrève (FR)
(74) Mandataire: Weber, Etienne Nicolas
(86) Numéro de dépôt international: PCT/FR2000/001828
(87) Numéro de publication internationale: WO 2001/003171

(56) Documents cités:
- EP-A- 0 533 551
- EP-A- 0 905 767
- WO-A-98/52216

## Description

### Domaine technique

La présente invention concerne un procédé de réalisation d'un film mince de matériau solide. Elle concerne en particulier la réalisation d'un film mince d'un matériau semi-conducteur tel que par exemple le silicium.

### Etat de la technique antérieure

Le document FR-A-2 681 472 (correspondant au brevet américain 5 374 564 et au document EP-A-0533551) décrit un procédé de fabrication de films minces de matériau semi-conducteur. Ce document divulgue que l'implantation d'un gaz rare et/ou d'hydrogène dans un substrat en matériau semi-conducteur est susceptible de créer une couche de microcavités ou des microbulles (encore désignées par le terme "platelets" dans la terminologie anglo-saxonne) à une profondeur voisine de la profondeur moyenne de pénétration des ions implantés. Ce substrat est mis en contact intime, par sa face implantée avec un support servant de raidisseur. En outre, un traitement thermique est appliqué à une température suffisante pour induire une interaction (ou coalescence) entre les microcavités ou les microbulles conduisant à une séparation du substrat semi-conducteur en deux parties : un film mince semi-conducteur adhérant au raidisseur d'une part, le reste du substrat semi-conducteur d'autre part. La séparation a lieu au voisinage de l'endroit où les microcavités ou microbulles sont présentes, c'est-à-dire le long de la couche de microcavités. Le traitement thermique est tel que l'interaction entre les microbulles ou microcavités créées par implantation induit une séparation entre le film mince et le reste du substrat. Il y a donc transfert d'un film mince depuis un substrat initial jusqu'à un raidisseur servant de support à ce film mince.

Ce procédé peut également s'appliquer à la fabrication d'un film mince de matériau solide autre qu'un matériau semi-conducteur (un matériau conducteur ou diélectrique), cristallin ou non. Ce film peut être monocouche ou multicouche

Ainsi, l'implantation d'espèces gazeuses est apte à créer en profondeur des cavités ou microbulles ou microfissures qui vont former une couche fragilisée au voisinage de la profondeur à laquelle les ions s'arrêtent. En fonction de la nature et des conditions d'implantation, la zone implantée est plus ou moins fragile. Elles sont choisies de façon que la surface implantée du substrat ne présente aucune déformation. Si des déformations de cette surface apparaissent, sous forme de cloques (ou "blisters" en anglais), ces déformations traduisent une trop forte fragilisation de la zone implantée.

Le document FR-A-2 681 472 enseigne que, pour obtenir le report d'un film mince sur un support, il est nécessaire de solidariser le substrat implanté et le support (ou raidisseur) avant de provoquer la séparation du film mince d'avec son substrat d'origine, cette séparation pouvant résulter d'un traitement thermique et/ou d'un traitement mécanique (comme l'enseigne le document FR-A-2 748 851). La solidarisation est obtenue par la mise en contact intime du substrat implanté et du support par l'intermédiaire d'un collage par adhésion moléculaire, d'une colle ou à l'aide d'un composé intermédiaire (couche isolante, couche conductrice, etc.). Cette solidarisation n'est possible que si la surface implantée ne possède pas de déformation, donc si des cloques ne sont pas apparues.

Dans certains cas, il n'est pas possible de solidariser le substrat implanté et le support servant de raidisseur, notamment à cause de coefficients de dilatation thermique différents. Il arrive aussi que les forces de collage ne sont pas suffisantes pour provoquer l'effet raidisseur. Il faut donc, pour obtenir un film mince par exemple monocristallin sur un support quelconque, utiliser un procédé dérivé de celui divulgué par le document FR-A-2 681 472, comme par exemple le procédé divulgué par le document FR-A-2 738 671 (correspondant au brevet américain 5 714 395). Selon ce procédé, pour obtenir la séparation du film mince de son substrat d'origine, il faut que les espèces gazeuses implantées se trouvent à une profondeur suffisante et/ou que l'on dépose, après l'étape d'implantation, une couche d'un matériau permettant de rigidifier la structure pour obtenir la séparation au niveau de la zone implantée. Le film obtenu est alors autoporté.

Pour les deux procédés mentionnés ci-dessus, la rugosité de surface du film mince après transfert est plus ou moins forte, selon les conditions d'implantation et/ou de séparation (traitement thermique et/ou mécanique) utilisées pour obtenir cette séparation. Il peut alors être intéressant de fragiliser de façon plus importante la zone contenant les cavités. Il serait ainsi possible d'obtenir la séparation de façon plus facile que dans le cas habituel, c'est-à-dire que la séparation pourrait se faire à l'aide de forces mécaniques plus faibles et/ou à l'aide d'un budget thermique plus faible. Cela est particulièrement intéressant pour des structures composées de matériaux ayant des coefficients de dilatation thermique différents et qui présentent des températures limites de chauffage.

Parmi les différents moyens permettant de fragiliser la zone implantée on peut citer l'augmentation de la dose des espèces gazeuses implantées et/ou la réalisation d'un traitement thermique qui peut correspondre au traitement thermique divulgué dans le document FR-A-2 681 472. Cependant, comme indiqué plus haut, il faut limiter la dose implantée et/ou le budget thermique avant l'étape de solidarisation pour éviter des déformations de la surface implantée.

Ainsi, il n'existe pas de moyen acceptable pour fragiliser davantage la zone implantée avant de mettre en oeuvre l'étape de séparation. L'existence d'un tel moyen permettrait de diminuer les budgets thermiques et/ou les forces mécaniques permettant la séparation. On pourrait ainsi reporter des films minces sur des supports ne supportant pas les températures élevées en utilisant le procédé divulgué par le document FR-A-2 681 472. On pourrait également obtenir de façon plus facile la séparation de films épais en utilisant le procédé divulgué par le document FR-A-2 738 671. Ces films épais pourraient ensuite être reportés sur tout type de support, même ceux qui ne permettent pas d'obtenir des forces de collage importantes entre le film et le support. En outre, une fragilisation plus importante de la zone implantée permettrait, tout en favorisant la fracture, de diminuer la rugosité de la surface libre du film après transfert. ,

Le problème posé est donc de parvenir à fragiliser davantage la zone implantée sans induire de cloques sur la surface implantée du substrat d'origine.

Le document WO-A-98/52216 divulgue un procédé de clivage d'un substrat, utilisable en particulier pour la production de substrats SOI. Le procédé comprend l'introduction de particules à travers une surface d'un substrat de manière à définir une couche de substrat à détacher. Ensuite, un clivage du substrat est amorcé à partir d'une région déterminée du substrat en fournissant de l'énergie à cette région déterminée (par exemple au moyen d'un fluide). Le clivage se propage ensuite, permettant à une couche du substrat de se détacher.

Le document EP-A-0 905 767 divulgue un développement du procédé de fabrication de films minces décrit dans le document FR-A- 2 681 472. Le développement consister à éliminer une couche de défauts apparue lors de l'étape d'implantation ionique. Cette élimination est obtenue au moyen d'une gravure en phase vapeur.

### Exposé de l'invention

L'invention apporte une solution à ce problème. Il est proposé d'appliquer une pression sur la face implantée du substrat, au moins pendant une partie de la coalescence des microcavités, afin de favoriser cette coalescence et d'empêcher les espèces gazeuses implantées de s'échapper du substrat. On augmente ainsi la fragilisation.

L'invention a donc pour objet un procédé de réalisation d'un film mince à partir d'un substrat présentant une face plane le substrat étant constitué, au moins du côté de ladite face plane, d'un matériau semi-conducteur, le procédé, comprenant :
- l'implantation d'espèces gazeuses dans le substrat pour constituer une couche de microcavités située à une profondeur par rapport à ladite face plane correspondant à l'épaisseur du film mince désiré, les espèces gazeuses étant implantées dans des conditions susceptibles de fragiliser le substrat au niveau de la couche de microcavités,
- la séparation partielle ou totale du film mince du reste du substrat, cette séparation, comportant une étape d'apport d'énergie thermique et l'application d'une pression sur ladite face plane du substrat,
caractérisé en ce que ladite pression est appliquée de manière uniforme sur ladite face plane.

Le document "Mechanistic Studies of Silicon Wafer Bonding and Layer Exfoliation" de M.K. WELDON et al., paru dans Electrochemical Society Proceedings, volume 97-36, précise que l'utilisation d'une contrainte compressive sur une structure collée, constituée d'un substrat implanté et d'un raidisseur, permet de fermer les microfissures et d'éviter l'exfoliation alors qu'une tension externe uniforme

peut conduire à l'exfoliation à plus basse température. Il mentionne également que l'application d'une pression uniforme à plus faibles températures peut permettre un développement des microfissures plus uniforme de telle façon qu'en relâchant la pression et en chauffant, une exfoliation plus uniforme peut être obtenue. Dans ce document, la pression appliquée permet l'obtention de microfissures homogènes mais ne renseigne pas sur l'augmentation de la fragilisation de la zone implantée par l'augmentation de la taille des microfissures. Ainsi, dans ce document, pour obtenir l'exfoliation il faut relâcher la pression et chauffer à une température a priori supérieure à celle utilisée pour l'application de la pression. Dans ce document, la pression appliquée n'est pas utilisée contrairement à l'invention pour augmenter la fragilisation de la zone implantée et donc pour diminuer le budget thermique et/ou les forces mécaniques permettant l'obtention du film mince. De plus, selon la présente invention, la séparation peut être obtenue sous pression. En outre, selon un mode avantageux de l'invention, la pression appliquée peut être ajustée en cours de procédé suivant l'évolution des phases gazeuses présentes dans les microcavités.

On entend par espèces gazeuses des éléments, par exemple d'hydrogène ou de gaz rares, sous leur forme atomique (par exemple H) ou sous leur forme moléculaire (par exemple H₂) ou sous leur forme ionique (par exemple H⁺, H⁺₂) ou sous leur forme isotopique (par exemple deutérium) ou sous forme isotopique et ionique.

Par ailleurs, on entend par implantation ionique tout type d'introduction des espèces définies précédemment, seul ou en combinaison, tel que le bombardement ionique, la diffusion, etc.

L'énergie thermique conduit, quel que soit le type de matériau solide, à la coalescence des microcavités ou microfissures, ce qui amène une fragilisation de la structure au niveau de la couche de microcavités. Cette fragilisation permet la séparation du matériau sous l'effet de contraintes internes et/ou de pression dans les microcavités, cette séparation pouvant être naturelle ou assistée par application de contraintes externes.

L'application de pression permet de favoriser la coalescence des microcavités tout en évitant la formation de cloques sur la face plane. Cette pression dépend de l'état de contrainte de la zone implantée.

Par séparation partielle, on entend une séparation comportant des points d'attache entre le film mince et le reste du substrat.

Ladite pression peut être une pression gazeuse et/ou une pression mécanique produite par exemple par un piston.

Le procédé peut comprendre en outre, après l'implantation des espèces gazeuses, la solidarisation d'un épaississeur sur ladite face plane. L'épaississeur peut être constitué par une plaquette qui est, par exemple, solidarisée par collage moléculaire avec ladite face plane. L'épaississeur peut aussi être constitué par un dépôt d'un ou de plusieurs matériaux. La pression peut alors être appliquée par l'intermédiaire de l'épaississeur. Cet épaississeur joue le rôle de raidisseur. Dans ce cas, la pression permettant de favoriser la coalescence des microcavités et d'éviter la formation de cloques tient compte de l'épaississeur. En effet, celui-ci peut induire des contraintes sur la structure, favorisant la coalescence des microcavités.

Avantageusement, au cours de la réalisation de la coalescence d'au moins une partie des microcavités, ladite pression est ajustée pour rester légèrement au-dessus d'une pression, dite pression limite, au-dessous de laquelle il y a apparition de cloques sur ladite face plane et au-dessus de laquelle il n'y a pas apparition de cloques sur ladite face plane. Ceci permet d'éviter l'application de surpressions inutiles.

La pression limite évolue dans le temps avec l'évolution de la coalescence des microcavités. Aussi, la pression utilisée selon l'invention peut être la pression limite maximale ou être une pression limite appliquée progressivement durant le procédé et qui varie en fonction de la coalescence des microcavités qui dépend en particulier du budget thermique (temps, température). La pression limite dépend donc du budget thermique. Ainsi par exemple pour un film de 300 nm de Si et de 5 µm de SiO₂, pour un recuit à 450°C à durée donnée, il faut appliquer une pression de l'ordre de quelques bars pour avoir la séparation alors que sans l'apport de pression, c'est-à-dire à pression atmosphérique, il est nécessaire de recuire à plus de 470°C, pour la durée donnée, pour avoir la séparation et l'obtention d'un film.

La réalisation de la coalescence peut être menée de telle façon que la séparation du film mince du reste du substrat est obtenue par leur simple écartement.

Selon un autre mode de mise en oeuvre, la séparation du film mince du reste du substrat est obtenue par l'application d'un traitement thermique et/ou par l'application de forces mécaniques.

On peut utiliser comme substrat de départ un substrat ayant déjà servi pour fournir, par ledit procédé, un film mince. Ce substrat ayant déjà servi peut être par exemple poli pour offrir une nouvelle face plane.

Eventuellement, le substrat supporte, du côté de ladite face plane, une ou plusieurs couches homogènes et/ou hétérogènes. Il peut comprendre, du côté de ladite face plane, tout ou partie d'au moins un dispositif électronique et/ou d'au moins un dispositif électro-optique.

L'invention permet, par l'utilisation d'une pression, d'obtenir des films autoportés de plus faible épaisseur qu'avec un procédé sans pression. En effet, la pression évite la relaxation des microcavités sous forme de cloques et permet l'interaction de ces microcavités pour conduire à la séparation.

L'invention permet également de différer la séparation du film mince par la mise en oeuvre d'une étape supplémentaire consistant à appliquer une surpression sur le film mince.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1 à 3 illustrent de manière schématique les différentes étapes du procédé de réalisation d'un film mince selon la présente invention,
- la figure 4 est un diagramme montrant l'évolution, en fonction du temps, de la pression appliquée sur la face implantée d'un substrat au cours d'une étape du procédé de réalisation d'un film mince selon la présente invention.

### Description détaillée de mode de réalisation de l'invention

Le principe mis en oeuvre dans l'invention repose sur l'utilisation de la pression au cours d'un ou de plusieurs traitements thermiques pour fragiliser la zone implantée tout en empêchant la formation de cloques.

La coalescence peut être réalisée en combinant un cycle de traitement thermique associé à un cycle de mise sous pression de façon à pouvoir augmenter le phénomène de fragilisation sans création de cloques-sur la face implantée. La pression peut être une pression de gaz. Le phénomène de fragilisation peut être mené jusqu'à la séparation totale des deux parties du substrat. En effet, pendant la réalisation de la coalescence, le processus de fragilisation du substrat à la profondeur d'implantation des ions se développe et peut aller au-delà des limites qu'un simple traitement thermique permettrait. La pression appliquée sur la face implantée du substrat permet ce résultat en empêchant la formation de cloques sur la face implantée et en empêchant aussi certaines cloques d'exploser comme cela peut se produire en l'absence de pression appliquée. On fragilise ainsi beaucoup le substrat le long de la couche de microcavités.

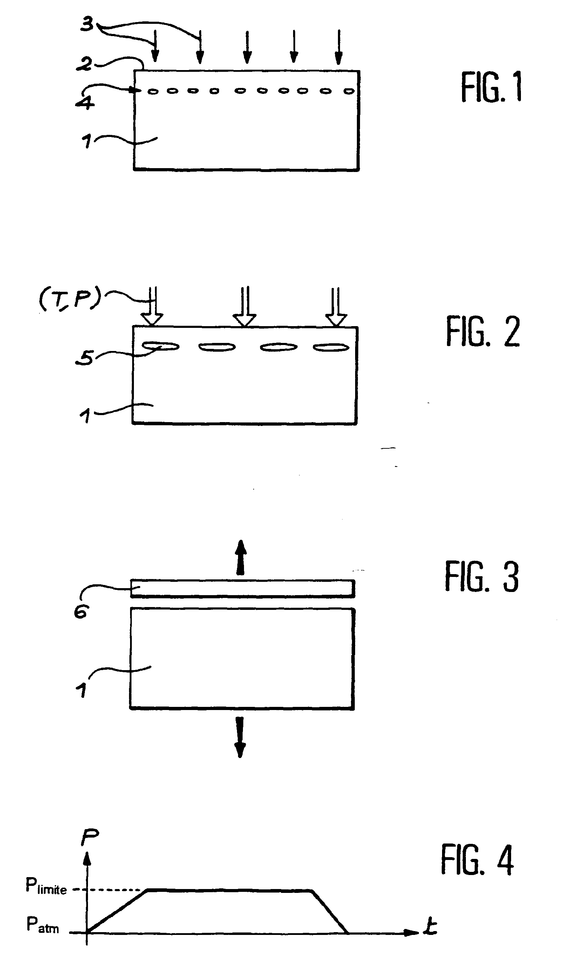

Les figures 1 à 3 sont des vues transversales d'un substrat semi-conducteur auquel le procédé selon l'invention est, appliqué.

Le substrat semi-conducteur 1 présente une face plane 2. Par face plane, on entend une face dont le plan moyen est plan. Cela comprend les plaques qui présentent une micro-rugosité de surface dont les valeurs de rugosité vont de quelques dixièmes de nanomètres à plusieurs centaines de nanomètres. Les inventeurs de la présente invention ont pu mettre en évidence qu'une implantation à travers une surface présentant une micro-rugosité, par exemple d'une valeur RMS (valeur quadratique moyenne) de 10 nm, ne perturbe pas le mécanisme de fragilisation et la fracture subséquente. Cette constatation est intéressante car cette rugosité est de l'ordre de grandeur de la rugosité de la face libre du film après transfert. Il est donc possible dans ces conditions de recycler plusieurs fois le même substrat sans recourir à un polissage de surface. Dans certains cas, cette face peut avoir une topologie qui sera éliminée au cours de la préparation de surface par exemple par polissage mécano-chimique.

La figure 1 illustre l'étape d'implantation d'espèces gazeuses. La face plane 2 est bombardée par exemple par des ions d'hydrogène, comme l'enseigne le document FR-A-2 681 472. Ce bombardement ionique est figuré par les flèches 3. On crée ainsi une couche de microcavités 4.

Eventuellement, le procédé selon l'invention peut comprendre une opération d'épaississement du film mince désiré. On peut par exemple, après l'étape d'implantation, rapporter par collage par adhésion moléculaire, ou par un autre type de collage, une plaquette sur la face implantée du substrat. On peut pour cela utiliser un équipement qui permet la mise en contact du substrat et de la plaquette dans une enceinte sous pression. L'application d'une pression sur la face plane du substrat peut alors se faire simultanément avec le collage de la plaquette d'épaississement.

Cette opération d'épaississement est avantageuse à réaliser en utilisant un procédé dérivé de celui divulgué dans le document FR-A-2 738 671. On peut par exemple déposer sur la face plane du substrat un ensemble de matériaux pour le rigidifier. Ces dépôts peuvent être des croissances épitaxiales ou hétéroépitaxiales ou des dépôts de matériaux amorphes ou polycristallins. A titre d'exemple, du silicium peut être déposé sur la face plane d'un substrat déjà implanté. Qu'il soit collé ou déposé, le matériau rapporté peut être qualifié d'épaississeur.

Pour des conditions expérimentales données (matériaux, ions, dose, énergie, température d'implantation et de recuit), pour chaque épaisseur de film mince (épaissi ou non) il existe une valeur limite pour la pression appliquée sur la face plane du substrat ou Pₗᵢₘᵢₜₑ au-dessous de laquelle il y a apparition de cloques sur la face plane et au-dessus de laquelle il n'y a pas apparition de cloques sur la face plane. Par exemple, Pₗᵢₘᵢₜₑ vaut 20 bars pour une épaisseur totale de 2 µm de silicium et vaut la pression atmosphérique pour 5 µm de silicium. Il est donc possible, lors de la réalisation de l'étape de coalescence selon l'invention, d'ajuster la pression au fur et à mesure du déroulement de l'étape pour que celle-ci reste au voisinage de Pₗᵢₘᵢₜₑ. Ceci permet d'éviter l'application de surpressions inutiles.

Pₗᵢₘᵢₜₑ est aussi fonction de la quantité restante d'espèces gazeuses introduites lors de l'implantation ionique. Cette quantité de gaz peut évoluer au cours du temps du fait de la diffusion du gaz, activée en particulier par la température, et du fait de la croissance des microcavités qui contiennent ce gaz. La pression limite permet d'éviter la formation de cloques mais ne doit pas limiter la croissance des cavités ou microfissures présentes au voisinage de la profondeur d'implantation. Lorsque les micro-fissures augmentent de taille, la même quantité de gaz occupe un volume plus grand et en conséquence Pₗᵢₘᵢₜₑ diminue. Il est ainsi possible de déterminer une étape de réalisation de la coalescence telle que la pression exercée et la pression limite suivent chacune un cycle commençant à la pression atmosphérique et y revenant. La pression effectivement exercée reste supérieure ou égale à la pression limite. On récupère ainsi en fin de cycle, à la pression atmosphérique, une couche fragilisée.

Sous certaines conditions il est aussi possible que la séparation totale du substrat en deux parties intervienne durant l'étape de réalisation de la coalescence. Le cycle est alors terminé.

La figure 2 illustre l'étape de réalisation de la coalescence des microcavités par apport d'énergie thermique T et application de pression P. La pression appliquée correspond par exemple au cycle du diagramme de la figure 4, représentant l'évolution de la pression P en fonction du temps t. La pression appliquée suit le cycle pression atmosphérique (Pₐₜₘ) - pression limite (Pₗᵢₘᵢₜₑ) - pression atmosphérique (Pₐₜₘ). Les microcavités ont tendance à coalescer pour former des microfissures 5.

La figure 3 illustre l'étape de séparation à l'issue de laquelle un film mince 6 est détaché du reste du substrat 1. Deux cas peuvent se présenter à l'issue de l'étape précédente : le film peut ne pas être totalement séparé du substrat ou en être totalement séparé.

Le procédé peut être mené de façon que le film mince ne soit pas totalement séparé de son substrat d'origine. Dans ce cas, le film mince peut être par exemple récupéré grâce à un support raidisseur, comme l'enseigne le document FR-A-2 681 472, rendu solidaire de la face implantée du substrat. Grâce à l'invention, cette récupération est plus facile car la fragilisation de la zone implantée est plus grande. Ceci signifie que les budgets thermiques nécessaires sont plus faibles et/ou que l'énergie d'arrachement nécessaire est plus faible. L'avantage d'un budget thermique (temps et/ou température) plus faible est la possibilité d'associer des matériaux ayant des coefficients de dilatation thermique différents. L'avantage d'une énergie d'arrachement plus faible est la possibilité de choisir une énergie de liaison du raidisseur plus faible, ce qui peut permettre la séparation ultérieure plus aisée du film mince et du raidisseur conformément à l'enseignement du document FR-A-2 725 074.

Ce substrat raidisseur peut être par exemple une plaque de silicium, un film souple par exemple en polymère, une céramique. La plaque peut être solidarisée sur le raidisseur à l'aide de colle ou par adhésion moléculaire, par l'intermédiaire éventuellement d'une couche d'interface par exemple en SiO₂.

Le procédé peut être mené de façon que le film mince soit totalement séparé de son substrat d'origine. Le collage d'un support raidisseur n'est pas forcément nécessaire. On peut obtenir un film autoporté comme l'enseigne le document FR-A-2 738 671. Cependant, grâce à l'invention les films minces peuvent être obtenus pour des épaisseurs,beaucoup plus faibles. A titre d'exemple, dans le cas du silicium monocristallin l'énergie minimum requise pour l'implantation ionique est de 500 keV selon le document FR-A-2 738 671. Grâce à l'invention, l'application d'une pression de 20 bars permet d'abaisser l'énergie d'implantation minimum (pour se passer de raidisseur) à environ 150 keV. Il est alors possible d'utiliser des implanteurs standard.

A titre d'exemple, on va maintenant décrire l'obtention d'un film de silicium selon la présente invention. La face plane d'un substrat de silicium est bombardée par des protons à une dose susceptible de conduire à l'apparition de cloques sur la face bombardée au cours d'un traitement thermique à 500°C. Cette dose peut être de l'ordre de 10¹⁷ cm⁻² pour une énergie d'implantation de 150 keV. Dans une première phase, on réalise un traitement thermique classique pour activer le mécanisme de croissance des microcavités (par exemple à 250°C pendant 2 heures). Dans cette première phase, l'application d'une pression n'est pas nécessaire car la coalescence des microcoavités n'est pas suffisante pour conduire à la formation de cloques détectables : la pression limite est inférieure ou égale à la pression atmosphérique. Dans une deuxième phase, la face implantée du substrat est mise sous pression (20 bars) et la température est élevée de 300 à 400°C en 15 minutes pour rester stationnaire pendant 1 heure. On obtient alors la séparation totale entre les deux parties du substrat. La température est alors abaissée et la pression est ramenée à la pression atmosphérique. Le film mince peut alors être récupéré.

Dans le cas où un support raidisseur est utilisé, la fragilisation de la zone implantée est obtenue sous pression et la température est diminuée pour relaxer la pression induite par la quantité de gaz et la température. En effet, il faut tenir compte du fait que la diminution de température entraîne une nette diminution de la pression à l'intérieur des microcavités ou des microfissures.

Ce procédé de l'invention présente de nombreux avantages. Il permet d'obtenir des fractures avec des rugosités plus faibles que celles obtenues avec les procédés de l'art connu. Ceci permet de diminuer l'épaisseur à enlever éventuellement par polissage, par exemple, lors de la réalisation de substrats Silicium-Sur-Isolant (substrats SOI). Le polissage introduisant une dispersion d'épaisseur qui est fonction de l'épaisseur enlevée, l'invention permet de réaliser des substrats SOI plus homogènes en épaisseur. De plus, la zone perturbée après fracture étant plus faible, l'invention procure une diminution du nombre de défauts résiduels dans le film mince.

La possibilité d'épaissir permet de réaliser des films plus épais, par exemple d'une dizaine de micromètres ou plus. Ces films minces peuvent servir pour fabriquer des structures SOI épaisses destinées à la réalisation de dispositifs de puissance ou pour réaliser des substrats pour la fabrication de cellules solaires en "couche fine".

Le procédé de l'invention permet d'utiliser plusieurs fois le substrat d'origine après éventuellement un polissage de la face révélée du substrat après le détachement du film mince.

Le procédé est applicable aux matériaux semi-conducteurs ainsi qu'aux autres matériaux monocristallins ou non.

## Revendications

1. Procédé de réalisation d'un film mince (6) à partir d'un substrat (1) présentant une face plane (2) le substrat étant constitué, an moins du côté de ladite face plane (2), d'un matériau semi-conducteur, le procédé comprenant :
- l'implantation d'espèces gazeuses dans le substrat (1) pour constituer une couche de microcavités (4) située à une profondeur par rapport à ladite face plane (2) correspondant à l'épaisseur du film mince désire, les espèces gazeuses étant implantées dans des conditions susceptibles de fragiliser le substrat au niveau de la couche de microcavités,
- la séparation partielle ou totale du film mince (6) du reste du substrat (1), cette séparation comportant un apport d'énergie thermique, et l'application d'une pression sur la face plane du substrat,
**caractérisé en ce que** ladite pression est appliquée de manière uniforme sur ladite face plane (2).

2. Procédé selon la revendication 1, **caractérisé en ce que** ladite pression est une pression gazeuse.

3. Procédé selon la revendication 1, **caractérisé en ce que** ladite pression est une pression mécanique.

4. Procédé selon la revendication 3, **caractérisé en ce que** ladite pression mécanique est produite par un piston.

5. Procédé selon la revendication 1, **caractérisé en ce qu'**il comprend en outre, après l'implantation des espèces gazeuses, la solidarisation d'un raidisseur sur ladite face plane (2).

6. Procédé selon la revendication 5, **caractérisé en ce que** le raidisseur est constitué par une plaquette.

7. Procédé selon la revendication 6, **caractérisé en ce que** la plaquette est solidarisée par collage moléculaire avec ladite face plane (2).

8. Procédé selon la revendication 5, **caractérisé en ce que** le raidisseur est constitué par un dépôt d'un ou de plusieurs matériaux.

9. Procédé selon l'une quelconque des revendications 5 à 8, **caractérisé en ce que** ladite pression est appliquée par l'intermédiaire du raidisseur.

10. Procédé selon la revendication 1, **caractérisé en ce que,** au cours de la réalisation de la coalescence d'au moins une partie des microcavités, ladite pression est ajustée pour rester légèrement au-dessus d'une pression, dite pression limite, au-dessous de laquelle il y a apparition de cloques sur ladite face plane (2) et au-dessus de laquelle il n'y a pas apparition de cloques sur ladite face plane (2).

11. Procédé selon la revendication 1, **caractérisé en ce que** la séparation du film mince (6) du reste du substrat (1) est obtenue par leur simple écartement.

12. Procédé selon la revendication 1, **caractérisé en ce que** la séparation du film mince (6) du reste du substrat (1) est obtenue par l'application d'un traitement thermique et/ou par l'application de forces mécaniques.

13. Procédé selon la revendication 1, **caractérisé en ce que** ledit substrat est un substrat ayant déjà servi pour fournir, par ledit procédé, un film mince.

14. Procédé selon la revendication 13, **caractérisé en ce que** le substrat ayant déjà servi est poli pour offrir une nouvelle face plane.

15. Procédé selon la revendication 1, **caractérisé en ce que** le substrat supporte,- du côté de ladite face plane, une ou plusieurs couches homogènes et/ou hétérogènes.

16. Procédé selon la revendication 1, **caractérisé en ce que** le substrat (1) comprend, du côté de ladite face plane, tout ou partie d'au moins un dispositif électronique et/ou d'au moins un dispositif électro-optique.

17. Procédé selon la revendication 1, **caractérisé en ce que** la séparation du film mince est différée par la mise en oeuvre d'une étape supplémentaire consistant à appliquer une surpression sur le film mince.

## Claims

1. Method for making a thin film (6) starting from a substrate (1) with a plane face (2), the substrate being composed of a semi-conducting maternal, at least on the side of said plane face (2), the method comprising:
- the implantation of gaseous species in the substrate (1) to make a layer of micro-cavities (4) at a depth from said plane face (2) corresponding to the thickness of the required thin film, the gaseous species being implanted under conditions that could weaken the substrate at the layer of micro-cavities,
- partial or total separation of the thin film (6) from the rest of the substrate (1), this separation comprising bringing thermal energy and applying a pressure on the plane farce of the substrate,
**characterized in that** said pressure is applied uniformly on said plane face (2).

2. Method according to claim 1, **characterized in that** said pressure is a gas pressure.

3. Method according to claim 1, **characterized in that** said pressure is a mechanical pressure.

4. Method according to claim 3, **characterized in that** said mechanical pressure is generated using a piston.

5. Method according to claim 1, **characterized in that** it also comprises bonding of a stiffener onto said plane face (2), after implantation of the gaseous species.

6. Method according to claim 5, **characterized in that** the stiffener is composed of a wafer.

7. Method according to claim 6, **characterized in that** the wafer is bonded by molecular bonding with said plane face (2).

8. Method according to claim 5, **characterized in that** the stiffener is formed by deposition of one or several materials.

9. Method according to any one of claims 5 to 8, **characterized in that** said pressure is applied through the stiffener.

10. Method according to claim 1, **characterized in that** said pressure is adjusted during the coalescence of at least part of the micro-cavities, to remain slightly above a pressure called the limiting pressure, below which blisters appear on said plane face (2) and above which blisters do not appear on said plane face (2).

11. Method according to claim 1, **characterized in that** the thin film (6) is separated from the rest of the substrate (1) by simply pulling them apart.

12. Method according to claim 1, **characterized in that** the thin film (6) is separated from the rest of the substrate (1) by application of a heat treatment and/or mechanical forces.

13. Method according to claim 1, **characterized in that** said substrate is a substrate that has already been used to produce a thin film according to said method.

14. Method according to claim 13, **characterized in that** previously used substrate is polished to provide a new plane face.

15. Method according to claim 1, **characterized in that** the substrate supports one or several homogeneous and/or heterogeneous layers on the side of said plane face.

16. Method according to claim 1, **characterized in that** the substrate (1) comprises all or part of at least one electronic device and/or at least one electro-optical device, on side of said plane face.

17. Method according to claim 1, **characterized in that** separation of the thin film is delayed by the application of an additional step that consists of applying an additional pressure onto the thin film.

## Patentansprüche

1. Verfahren zur Herstellung eines dünnen Films (6), ausgehend von einem eine ebene Fläche (2) aufweisenden Substrat (1), wobei das Substrat wenigstens auf der Seite der ebenen Fläche (2) aus einem Halbleitermaterial besteht und das Verfahren umfasst:
- die Implantation gasförmiger Spezies in das Substrat (1), um eine Mikrohohlräume-Schicht (4) zu bildern, die sich in Bezug auf die genannte ebene Fläche (2) in einer der Dicke des erwünschten dünnen Films entsprechenden Tiefe befindet, wobei die gasförmigen Spezies unter Bedingungen implantiert werden, die das Substrat auf Höhe der Mikrohohlräume-Schicht brüchig machen,
- die partielle oder totale Trennung des dünnen Films (6) vom Rest des Substrats (1), wobei diese Trennung eine Zufuhr von thermischer Energie und die Anwendung eines Drucks auf die ebene Fläche des Substrats erfordert,
**dadurch gekennzeichnet, dass** der genannte Druck gleichmäßig auf die genannte ebene Fläche (2) angewendet wird.

2. Verfahren nach Anspruch 1, **dadurch gekennzeichnet, dass** der genannte Druck ein Gasdruck ist.

3. Verfahren nach Anspruch 1, **dadurch gekennzeichnet, dass** der genannte Druck ein mechanischer Druck ist.

4. Verfahren nach Anspruch 3, **dadurch gekennzeichnet, dass** der genannte mechanische Druck durch einen Kolben erzeugt wird.

5. Verfahren nach Anspruch 1, **dadurch gekennzeichnet, dass** es, nach der Implantation der gasförmigen Spezies, die Realisierung einer Versteifung auf der genannten ebenen Fläche (2) umfasst.

6. Verfahren nach Anspruch 5, **dadurch gekennzeichnet, dass** die Versteifung durch ein Plättchen gebildet wird.

7. Verfahren nach Anspruch 6, **dadurch gekennzeichnet, dass** das Plättchen durch Molekularklebung mit der genannten ebenen Fläche (2) verbunden werden kann.

8. Verfahren nach Anspruch 5, **dadurch gekennzeichnet, dass** die Versteifung durch das Abscheiden eines oder mehrerer Materialien realisiert wird.

9. Verfahren nach einem der Ansprüche 5 bis 8, **dadurch gekennzeichnet, dass** der genannte Druck durch die Versteifung angewendet wird.

10. Verfahren nach Anspruch 1, **dadurch gekennzeichnet, dass** im Laufe des Zusammenwachsens wenigstens eines Teils der Mikrohohlräume der genannte Druck so angepasst wird, dass er etwas oberhalb eines Drucks bleibt, Grenzdruck genannt, unterhalb dem auf der genannten ebenen Fläche (2) Blasen auftreten und oberhalb dem auf der genannten ebenen Fläche (2) keine Blasen auftreten.

11. Verfahren nach Anspruch 1, **dadurch gekennzeichnet, dass** man das Trennen des dünnen Films (6) vom Rest des Substrats (1) durch einfaches Auseinandernehmen realisiert.

12. Verfahren nach Anspruch 1, **dadurch gekennzeichnet, dass** man das Trennen des dünnen Films (6) vom Rest des Substrats (1) durch Anwendung einer thermischen Behandlung und/oder durch Anwendung von mechanischen Kräften realisiert.

13. Verfahren nach Anspruch 1, **dadurch gekennzeichnet, dass** das genannte Substrat ein Substrat ist, das schon dazu gedient hat bzw. benutzt wurde, durch das genannte Verfahren einen dünnen Film zu liefern.

14. Verfahren nach Anspruch 13, **dadurch gekennzeichnet, dass** das schon benutzte Substrat poliert wird, um ihm eine neue ebene Fläche zu verleihen.

15. Verfahren nach Anspruch 1, **dadurch gekennzeichnet, dass** das Substrat auf der Seite der genannten ebenen Fläche eine oder mehrere homogene und/oder heterogene Schichten trägt.

16. Verfahren nach Anspruch 1, **dadurch gekennzeichnet, dass** das Substrat (1) auf der Seite der genannten ebenen Fläche wenigstens eine elektronische Vorrichtung, ganz oder teilweise, und/oder wenigstens eine elektrooptische Vorrichtung umfasst.

17. Verfahren nach Anspruch 1, **dadurch gekennzeichnet, dass** das Abtrennen des dünnen Films verzögert wird durch die Durchführung eines zusätzlichen Schrittes, darin bestehend, auf den dünnen Film einen Überdruck auszuüben.
